(19) **Europäisches Patentamt / European Patent Office / Office européen des brevets**

(11) **EP 3 008 152 B1**

(12) **EUROPEAN PATENT SPECIFICATION**

(45) Date of publication and mention of the grant of the patent:
**05.08.2020  Bulletin 2020/32**

(51) Int Cl.:
***H01L 31/0216*** (2014.01)

(21) Application number: **14811622.1**

(22) Date of filing: **10.06.2014**

(86) International application number:
**PCT/US2014/041682**

(87) International publication number:
**WO 2014/200985 (18.12.2014 Gazette 2014/51)**

(54) **CHEMICAL COMPOSITION FOR SEMICONDUCTOR MANUFACTURING PROCESSES**

CHEMISCHE ZUSAMMENSETZUNG FÜR HALBLEITERHERSTELLUNGSPROZESSE

COMPOSITION CHIMIQUE POUR PROCÉDÉS DE FABRICATION DE SEMI-CONDUCTEURS

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **11.06.2013  US 201361833706 P**
**12.06.2013  US 201361834153 P**

(43) Date of publication of application:
**20.04.2016  Bulletin 2016/16**

(73) Proprietor: **Specmat Inc.**
**North Olmsted, OH 44070 (US)**

(72) Inventors:
• **FAUR, Horia M.**
  **Medina, Ohio 44256 (US)**
• **FAUR, Maria**
  **North Olmsted, Ohio 44070 (US)**
• **FAUR, Mircea**
  **North Olmted, Ohio 44070 (US)**

(74) Representative: **Müller-Boré & Partner**
**Patentanwälte PartG mbB**
**Friedenheimer Brücke 21**
**80639 München (DE)**

(56) References cited:
**WO-A1-2012/036760**        **WO-A1-2012/036760**
**JP-A- 2006 324 507**        **US-A- 5 601 656**
**US-A1- 2007 163 618**       **US-A1- 2009 192 065**
**US-A1- 2010 101 453**       **US-A1- 2012 088 318**
**US-A1- 2012 178 257**       **US-A1- 2012 273 458**
**US-B1- 6 613 697**          **US-B1- 6 783 695**

• **NUTSU ET AL.: 'Solvent Extraction Equilibria of Acids. VII. The Co-extraction of Water with Strong Mineral Acids by Trioctylphosphine Oxide' BULLETIN OF THE CHEMICAL SOCIETY OF JAPAN vol. 52, no. 6, 1979, pages 1799 - 1801, XP008181643**

**Description**

The present disclosure relates generally to the field of semiconductors and/or semiconductor structures (e.g., solar cells, etc.), to chemical compositions for manufacturing such semiconductors and/or semiconductor structures, and/or to methods for manufacturing such semiconductors and/or semiconductor structures. The present disclosure also relates to chemical compositions and methods for controlling surface passivation, dead layer etchback, anti-reflective, potential induced degradation, and other properties of semiconductor surfaces used for various semiconductor applications including, but not limited to, solar cells.

As is known to those of skill in the art, silicon dioxide ($SiO_2$) forms the basis of the planar technology. In industrial practice the dielectric coatings for electronic and photonic devices are most frequently formed by thermal oxidation of silicon (Si) in dry or wet oxygen ambient at temperatures ranging from 900°C to 1200°C. $SiO_2$ can also be deposited by chemical vapor deposition (CVD) techniques at lower temperatures (200°C to 900°C) on various substrates.

Thermal and CVD-grown $SiO_2$ based layers are used as, for example, diffusion masks, to passivate device junctions, as electric insulation, as dielectric material in Si technology, and as capping layers for implantation-activation annealing in III-V compound semiconductor technology.

The growth of dielectric films at low temperatures is very attractive for most device applications due to reduced capital costs, improved output levels, as well as addressing some of the technological constraints associated with the growth of dielectric thin films using conventional high-temperature growth/deposition techniques. Thin dielectric film near room-temperature growth/deposition techniques are known in the art and are chiefly used for microelectronic/photonic (optoelectronic) device applications. An example of these low temperature methods are the physical vapor deposition processes which include: (i) nonreactive (conventional) or reactive resistive; (ii) induction or electron beam evaporation; (iii) reactive or nonreactive DC or RF magnetron; and (iv) ion-beam sputtering processes.

The room temperature growth of dielectric layers on semiconductor surfaces using anodic oxidation is also known. Such processes are able to grow $SiO_2$ layers on Si substrates that are up to 200 nm thick and typically consume about 0.43 of the oxide thickness from the underlying Si substrate. This in principle could be used to produce a first layer ARC in a multi-layer ARC structure that passivates the silicon surface. Etching back the so called dead layer of the emitter's surfaces (i.e., the emitter's surfaces not covered by metallization) would be a useful bonus for solar cells and other electronics and optoelectronics device applications.

The use of organometallic solutions to deposit $SiO_2$ dielectric layers is known in the art. The dielectric layer is applied either by dipping the substrate into the organometallic solution, by spraying the organometallic solution on the substrate, or by spinning the substrate after a small amount of the organometallic solution is applied thereto. After the organometallic solution is applied, it is necessary to drive off the solvent part of the solution by heating the substrate to about 400°C.

A large number of patents, patent applications, and published papers describe near room temperature related processes for the deposition of $SiO_2$ and $SiO_{2-x}F_x$ layers on various substrates, including silicon surfaces. The so called liquid-phase deposited (LPD) $SiO_2$ technique was initially proposed in 1950 by Thomsen et al. for depositing $SiO_2$ on the surface of soda lime silicate glass. LPD is based on the chemical reaction of $H_2SiF_6$ with water to form hydrofluoric acid and solid $SiO_2$. The $H_2SiF_6$ solution is initially saturated with $SiO_2$ powder (usually in a sol-gel from). Before immersing the glass into the solution a reagent that reacts with the hydrofluorosilicilic acid such as boric acid may be added to the solution to supersaturate with silica. As shown by Sang M. Han et al., the LPD process is a competition between the deposition and etching of $SiO_2$. Regardless of the small variations in formulations, the overall reversible chemical reaction is:

$$H_2SiF_6 + 2\ H_2O \leftrightarrow 6\ HF + SiO_2$$

One of the major disadvantages of the $SiO_2$ LPD method described above is a very low deposition rate. Using hydrofluorosilicilic acid, $SiO_{2-x}F_x$ deposition rates of 110 nm/hour were claimed by C. F. Yeh et al. The inventors of the present patent application have experimented with the LPD method and discovered that the LPD $SiO_2$ has relatively poor adhesion to the Si surfaces and the maximum growth rate obtained was in actuality less than about 25 nm/hour. Chien-Jung Huang used an optimized $SiO_2$ LPD on Si to show that the maximum $SiO_2$ growth rate on Si is 360 Angstroms/hour (i.e., 36 nm/hour).

High Growth Rate RTWCG SiOZ Thin Film Dielectrics: United States Patent Nos. 6,080,683; 6,593,077; and 6,613,697, as well as WO 2012/036760 describe in detail a fast SiOZ growth technique using the so called Room Temperature Wet Chemical Growth (RTWCG) of SiOZ based thin film dielectric layers on silicon (Si) substrates for a variety of electronics including, but not limited to, microelectronics and optoelectronics (photonics) applications. The above patents and/or published patent applications describe Room Temperature Wet Chemical Growth (RTWCG) methods and processes of SiOZ thin film coatings which can be grown on various substrates. Suitable substrates include but are not restricted to Si, Ge, III-V, I-III-VI, and II-VI compound semiconductors. The RTWCG method and process is very well suited to grow thin films on the Si substrates used in the manufacture of silicon-based electronic and photonic (optoelectronic) device applications.

The term RTWCG process of SiOZ dielectric layers, as used herein, means a room temperature (e.g., from about 10°C to about 45°C) wet chemical growth process of $Si_xO_yZ_z$ layers where x is from 0.9 to 1.1, y is from 0.9 to 2, and z is from 0 to 1. Si stands for silicon, O stands for oxygen, and Z is either fluorine (F), carbon (C), nitrogen (N) or a combination of these with iron (Fe), palladium (Pd), titanium (Ti), or other trace-level metallic and/or non-metallic contaminants depending on the redox system or non-invasive additives used. The trace level metallic and/or non-metallic elements include, but are not limited to, any one or more of the elements or elemental dopants known to those with skill in the semiconductor arts. Additionally, the term "SiOZ" as utilized throughout this specification and claims is defined as detailed above with regard to the formula $Si_xO_yZ_z$ and is defined components.

United States Patent Nos. 6,080,683, entitled "Room Temperature Wet Chemical Growth Process of SiO Based Oxides on Silicon;" and 6,593,077 entitled "Method of Making Thin Films Dielectrics Using a Process for Room Temperature Wet Chemical Growth of SiO Based Oxides on a Substrate", both describe RTWCG SiOZ methods and processes on a semiconductor substrate comprising: (a) providing a reaction mixture comprising of a silicon source, a pyridine compound , and an aqueous reduction oxidation solution; (b) additives to enhance the reaction; and (c) reacting the mixture with the substrate to form the silicon oxide layer.

High growth rate RTWCG SiOZ thin films, as reveled in United States Patent Nos. 6,080,683 and 6,593,077 were grown using the RTWCG process on silicon and other semiconductor substrates using commercial-grade 34 percent $H_2SiF_6$. Other liquid precursors included, but were not limited to, silicon sources such as $(NH_4)_2SiF_6$, aqueous compounds such as $K_3Fe(CN)_6$ and Fe-EDTA, and an electron transfer component such as N-(n-butyl)pyridinium chloride (n-BPCl). High growth-rate growth of SiOZ oxide on silicon substrates was achieved by using commercial grade organic and inorganic silicon sources, a pyridine compound (i.e., N-(n-butyl)pyridinium chloride), redox aqueous solutions based on $Fe^{2+}/Fe^{3+}$, and non-invasive additives including NaF, KOH, $NH_4F$, and $HF_{(aq)}$. In one embodiment of the above inventions, the SiOZ growth solution was made by mixing 2 to 5 volume parts 34 percent $H_2SiF_6$ with 2 to 5 volume parts 0.5 M $K_4Fe(CN)_{6(aq)}$, 1 to 3 parts 60 percent $H_2TiF_{6(aq)}$, and 0 to 4 volume parts 5 percent n-BPCl$_{(aq)}$. This solution was saturated with $SiO_2$-containing compounds such as silica, silica gel, and various other additives.

By using the above growth solution formulations, the SiOZ oxide layers grown on various semiconductor substrates have a relatively low growth rate and a relatively high metallic and non-metallic impurity concentration. They have inferior electric and dielectric properties compared to the SiOZ oxide layers grown using the growth solution formulations described by the United States Patent No. 6,613,697, entitled "Low Metallic Impurity SiO Thin Film Dielectrics on Semiconductor Substrates." The RTWCG SiOZ growth rate on Si surfaces described in the United States Patent No. 6,613,697 ranges from 1 nm/minute to over 100 nm/minute depending on the composition of the growth solution.

In one embodiment of United States Patent No. 6,613,697, all organic components of the growth solution were substituted with inorganic components. Only inorganic components were used for the silicon source and the pyridine-based compounds were eliminated. Various inorganic aqueous $Me^{+n}/Me^{+(n+m)}$ (were n is from 0 to 4 and m is from 1 to 4, inclusive) combinations of redox additives were added to the growth solution as per above. The RTWCG SiOZ thin film layers grew on various semiconductor substrates at a higher growth rate and with lower metallic and non-metallic impurity concentration. Also there was an improvement in the dielectric properties of the resulting thin films when compared to the RTWCG SiOZ thin films grown in solutions with organic components.

In one embodiment WO 2012/036760 discloses a RTWCG SiOZ growth solution formulation that eliminates the need for a silicon source, such as $H_2SiF_6$ or any other silicon source found in the prior art RTWCG SiOZ growth solution formulations. This embodiment requires HF concentrations ([HF]) to be from 10 percent to 40 percent.

Anti-Reflection Coatings Prior Art: Anti-reflection coatings (ARC) are included in a solar cell design to substantially reduce the amount of reflected light. Bare Si loses 42 percent of light with long wavelengths of 1.1 μm, 37 percent of light with wavelengths of 1 μm, and about 54 percent of light with short wavelengths of 0.4 μm. A textured front surface, such as regularly spaced pyramids or porous silicon (PS), can lower the AM 1.5 average weighted reflection to between 12 percent to 18 percent over the 0.4 μm to 1.2 μm wavelength range.

$$d_1 = \frac{\lambda_0}{4n_1}.$$

The optimal thickness of an anti-reflection coating is calculated by the following formula: For a quarter wavelength ARC made of a transparent material having a refractive index $n_1$, and a light incident on the coating with a free-space wavelength $\lambda_0$, the thickness which causes minimum reflection is $d_1$. Because the index of refraction is wavelength-dependent, near zero reflection can only occur for a single wavelength. The refractive index and thickness of an ARC must minimize the reflection of light with wavelengths of 0.6 μm since this wavelength is close to the peak power of the solar spectrum. The equations for multiple anti-reflection coatings are more complicated than that for a single layer (see Wang et al.). By properly adjusting the refractive index and thickness of two layers it is theoretically possible to produce two minima and an overall reflectance as low as 3 percent.

A proper SLAR on smooth surfaces (e.g., $MgF_2$, $SiO_2$, SiO, $SiN_x$, $TiO_2$ and $Ta_2O_5$) can reduce the AM 1.5 average weighted reflection (AWR) to a range between 12 percent to 16 percent over the 0.4 $\mu$m to 1.1 $\mu$m wavelength range. For an optimized CVD-deposited $SiN_x$ ARC, which is the norm for silicon solar cell ARC applications, the AM 1.5 AWR is about 12 percent with a simulated minimum AWR of 10.4 percent as calculated by Wright et al. on flat c-Si having an assumed film index of refraction, $n$, of 1.95, and thickness, $d$, of 81 nm.

Whether or not the simulated minimum $SiN_x$ SLAR AWR is achievable in a production environment remains to be seen. But even if the simulated reflectance is achieved, the reflective losses are still too high at 10.4 percent reflectivity. The industry would still need to create a practical low-cost way of further lowering the reflectance through a double layer ARC, a textured silicon solar cell surface, or both. However, this approach becomes cost prohibitive for most commercial solar cell applications.

For textured surfaces with well-designed single or double layer AR coatings such as $ITO/SiO_2$, $ZnS/MgF_2$, $TiO_2/MgF_2$, and $TiO_2/Al_2O_3$ the AM 1.5 AWR has been brought down to between 3 percent and 8 percent. A large number of studies on double layer ARCs have been reported. The most stable configuration with respect to variations in film thicknesses have been found to be designs with a high refractive index ($n$) on the substrate and a low refractive index towards the ambient (see Bauhaus et al.).

Both magnesium fluoride/zinc sulfide ($MgF_2/ZnS$) double layers deposited by electron beam sputtering (see Cid et al.) and titanium oxide ($TiO_2$) double layers deposited by Atmospheric Pressure Chemical Vapor Deposition (see Richards) show very low reflectance over a broad wavelength range. However, both techniques require a separate thermally-grown silicon oxide ($SiO_2$) layer for surface passivation. This essentially renders them a triple layer ARC with associated high costs and design flaws such as high absorption of near UV and blue light.

Two $TiO_2$ thin films were deposited on planar silicon wafers using atmospheric pressure chemical vapor deposition (APCVD) system under different deposition conditions. AWR values of 6.5 percent (measured) in air, and 7.0 percent (calculated) under glass were achieved for $TiO_2$ DLAR coatings (see Richards et al.).

Spin-coated $TiO_2$ single-layer, $SiO_2/TiO_2$ double-layer (DLAR), and $SiO_2/SiO_2$-$TiO_2/TiO_2$ triple-layer (TLAR) ARCs were deposited on smooth emitter Si solar cells [Lien et al] with average optical reflectances (from 400 nm to 1000 nm) around 9.3 percent, 6.2 percent and 3.2 percent, respectively. A 39 percent improvement in the efficiency of a c-Si solar cell was achieved with a TLAR ARC.

Jiao & Al claim a record photocurrent gain between 40 percent and 46 percent by using classical $TiO_2/SiO_2$ graded DLAR coating. According to Aiken, the complete elimination of reflection losses yields a maximum theoretical photocurrent gain after the ARC of approximately 53 percent.

A seven layer ARC design with graded-index AR coatings, measuring 60 to 160 nm thick, made of silicon dioxide ($SiO_2$) and titanium dioxide ($TiO_2$), was recently reported (see Kuo et al.). The bottom two layers are $TiO_2$, followed by three middle layers of co-sputtered $SiO_2$ and $TiO_2$. The top two layers consist of slanted nano-rods of $SiO_2$ with very low refractive indices of 1.22 and 1.09, the tilt angle of which is created using an oblique-angle deposition technique that precisely determines the refractive index. According to Kuo et al., the overall solar-to-electric efficiency improvement over bare silicon solar cells would be boosted from the 20.5 percent obtained with a quarter-wave coating to 42.7 percent.

Lipinski et al. reported the results of theoretical optical optimization of the graded index oxynitride ARC for silicon solar cells. Lipinski et al. used experimental optical data of $SiN_x$:H layers deposited by RF plasma enhanced chemical vapor deposition system. The highest improvement in short-circuit current (Jsc) of 44.6 percent was obtained with an $SiO_xN_y$ graded layer for $SiN_x$:H with a low refractive index (2.1 at 600 nm) and abrupt concentration profile which is characteristic of a DLAR $SiO_2$-$SiN_x$:H.

Layers of Stacked Dielectrics: A stacked dielectric is created by growing or depositing two or more distinct materials on top of one another. The materials most commonly utilized in the PV industry include silicon dioxide ($SiO_2$), hydrogenated amorphous silicon nitride (a-$SiN_x$:H), aluminum oxide ($Al_2O_3$), titanium oxide ($TiO_2$), and silicon oxynitride ($SiO_xN_y$). Stacked dielectrics are most commonly used in order to suppress reflection or for surface passivation. Layers such as a-$SiN_x$:H, $SiO_2$, or $Al_2O_3$ can reduce surface recombination if deposited or grown directly on the surface (first layer) - a significant loss mechanism in solar cells. For high efficiency crystalline silicon solar cell applications, thin film $SiO_2$ and $Al_2O_3$ layers are used for front and back surface passivation and as the first layer anti-reflection coating (ARC) in a multi-layer ARC structure. $SiO_xN_y$ or $SiN_x$ of low refractive index can be grown on top of $SiN_x$ layers of high refractive index to improve the transmission of light into the active parts of the cell.

Potential Induced Degradation (PID): Since PID is driven by voltage, heat, and humidity, all PV systems can be susceptible to PID and the associated power output drop of 30 percent or more. The failure mechanism depends on the module's voltage potential and leakage current to facilitate ion migration through the ARC from other parts of the module such as the glass, encapsulation, mount, or frame. Sodium ions are believed to be the most likely culprits but debate is ongoing concerning other ions such as aluminum, magnesium, and calcium which are present in the soda-lime glass commonly used in panels.

There are some recognized methods for mitigation of PID. Replacing soda-lime glass with quartz glass ensures that the solar glass is free of the suspected PID ions, of course, cost is a major barrier to implementing this fix. Properly grounding the panels helps prevent PID. At the cell level, utilizing higher IR $SiN_x$ in the ARC is another way of minimizing PID, although the drawback would be the utilization of a less-than ideal ARC and associated efficiency losses. Thermal $SiO_2$ as a first layer of a stacked ARC can also mitigate PID. The drawbacks of thermal oxidation are of course the cost of increasing process complexity as well as the damage caused by the high thermal budget the process requires.

The present disclosure relates generally to the field of semiconductors and/or semiconductor structures (e.g., solar cells, etc.), to chemical compositions for manufacturing such semiconductors and/or semiconductor structures, and/or to methods for manufacturing such semiconductors and/or semiconductor structures. The present disclosure also relates to chemical compositions and methods for controlling surface passivation, dead layer etchback, anti-reflective, potential induced degradation, and other properties of semiconductor surfaces used for various semiconductor applications including, but not limited to, solar cells.

The present invention is defined in claim 1 and relates to a liquid composition for SiOZ growth with reduced etchback properties as characterized in claim 1 that contains at least: (A) an iodine compound comprising $HIO_3$; (B) a first acid comprising HF; (C) a second, non-oxidizing, acid comprising HCl; and (D) water, wherein the composition comprises A weight percent of the iodine compound (A), B weight percent of the first acid (B), C weight percent of the second, non-oxidizing, acid (C), and D weight percent water, wherein the sum of A, B, C, and D is 100, wherein the iodine compound (A) is present in the range of about 0.01 weight percent to about 0.4 weight percent, wherein the first acid (B) is present in the range of about 0.1 weight percent to about 10 weight percent, wherein the second, non-oxidizing, acid (C) is present in the range of about 1 weight percent to about 50 weight percent, or even about 1 weight percent to about 30 weight percent, and D is the balance. The amount of B is preferably less than about 10 weight percent, such as about 7 weight percent or less. More specifically, A is $0.1317 \pm 0.1$ weight percent; B is $5.70 \pm 2.5$ weight percent; C is $25.00 \pm 12$ weight percent; and D is the balance. A dilute aqueous solution comprising the composition of the present invention and water can be provided.

The liquid composition described above can be a concentrate which is diluted with de-ionized (DI) water to form a dilution mixture, wherein the mixture has a dilution ratio (composition to DI water) of about 1:4 to about 1:26, or even about 1:4 to about 1:10.

The following embodiments correspond to possible uses of the composition of the present invention.

An embodiment relates to a method of growing a passivation oxide layer by contacting a semiconductor surface with the liquid composition or dilution mixture described above. The oxide can have a thickness of about 20 Angstroms to about 200 Angstroms, or even about 70 Angstroms to about 150 Angstroms. The semiconductor exhibits a sheet rho after SiOZ oxide growth of about 80 ohm/sq to about 110 ohm/sq, more specifically about 85 ohm/sq to about 100 ohm/sq. The semiconductor exhibits a sheet rho delta of about 2 ohm/sq to 30 ohm/sq, or of about 3 ohm/sq to about 20 ohm/sq, or even more specifically about $12 \pm 3$ ohm/sq. In another aspect of this embodiment, the semiconductor exhibits a reflectance minimum at a wavelength greater than the semiconductor would otherwise exhibit if the oxide had been formed by exposure to a growth formulation which lacks the non-oxidizing acid. For example, the wavelength corresponding to the minimum reflectance is red-shifted by about 20 nm to about 80 nm, or even from about 20 nm to 45 nm.

In still another embodiment, the present disclosure relates to a Room Temperature Wet Chemical Growth (RTWCG) SiOZ method, and process, for fabricating high-efficiency, low-cost, crystalline silicon solar cells and solar modules using the low-cost RTWCG SiOZ first layer based process, design, and technology. A simple n+/p or p+/n or a n+/p/p+ or p+/n/n+ efficiency enhanced solar cell structure design is utilized.

In still another embodiment, the present disclosure provides a RTWCG method for the fast growth of SiOZ thin film dielectric layers grown in low-[HF], non-metallic conditions using a modified RTWCG SiOZ.

In still another embodiment, the present disclosure provides a RTWCG SiOZ process that uses SiOZ growth solutions based on components that are plentiful and low in cost.

In still another embodiment, the present disclosure provides a high growth rate RTWCG SiOZ process, with good SiOZ thin film uniformity, low stress, good adhesion to silicon surfaces, and good conformity.

In still another embodiment, the present disclosure provides a RTWCG SiOZ process that produces SiOZ thin films that are stable after long term exposure to humidity, temperature variation, UV light, visible light, and plasma.

In still another embodiment, the present disclosure provides a RTWCG process where the SiOZ growth solution provides in-situ cleaning of the PSG, prior to the RTWCG SiOZ thin film growth on diffused Si surfaces.

In still another embodiment, the present disclosure provides a RTWCG SiOZ process whereas the SiOZ thin film passivates the Si solar cell surfaces.

In still another embodiment, the present disclosure provides a RTWCG SiOZ process whereas the SiOZ thin film mitigates potential induced degradation.

In still another embodiment, the present disclosure provides Si RTWCG SiOZ solar cell structure design, method, process, and technology for any smooth or textured emitter surface, and which is compatible with all crystalline Si materials including, but not limited to, semiconductor grade and solar grade Czochralski ("CZ") or float zone ("FZ") single crystal Si ("c-Si"), multi-crystalline Si ("mc-Si"), poly-Si, and string ribbon Si.

In still another embodiment, the present disclosure provides a n+/p-Si solar cell structure and technology that works equally well with p+/n-Si solar cell structure.

The present disclosure provides a composition for forming at least one PID-mitigating oxide layer comprising: (A) a compound comprising iodine; (B) a first acid comprising fluorine; (C) a second, non-oxidizing acid; and (D) water. A dilute aqueous solution comprising this composition through the addition of water can be provided.

The present disclosure provides a semiconductor device comprising at least one PID-mitigating oxide layer, wherein the PID-mitigating oxide layer is formed by treating the semiconductor device with the above composition for forming at least one PID-mitigating oxide layer.

The present disclosure provides a method of forming at least one PID-mitigating oxide layer, the method comprising the steps of: (i) supplying at least one semiconductor structure, at least one precursor semiconductor structure, and/or at least one semiconductor substrate; (ii) supplying at least one composition according to the above composition for forming at least one PID-mitigating oxide layer; and (iii) using the composition of Step (ii) to form at least one PID-mitigating layer on at least a portion of the at least one semiconductor structure, the at least one precursor semiconductor structure, and/or the at least one semiconductor substrate of Step (i).

The present disclosure provides a semiconductor structure and/or device comprising at least one reduced etchback layer, wherein the semiconductor structure and/or device is formed by treating the semiconductor device with the above composition for reducing etchback in a semiconductor structure and/or device.

In still another embodiment, the present disclosure provides a method of growing a SiOZ layer on at least one semiconductor structure and/or device using a reduced etchback growth composition, the method comprising the steps of: (A) supplying at least one semiconductor structure, at least one precursor semiconductor structure, and/or at least one semiconductor substrate; (B) supplying the composition of the invention for reducing etchback in a semiconductor structure and/or device; and (C) using the composition of Step (B) to form at least one oxide layer on at least a portion of the at least one semiconductor structure, the at least one precursor semiconductor structure, and/or the at least one semiconductor substrate of Step (A), where the formation of the at least one oxide layer results in a reduction in etchback when compared to any method that utilizes a composition other than a composition according to the above composition for reducing etchback in a semiconductor structure and/or device.

The present disclosure provides a low-[HF] RTWCG composition comprising: (A) a compound comprising iodine; (B) a first acid comprising fluorine; (C) a second, non-oxidizing acid; and (D) water, wherein the amount of [HF] in the low-[HF] composition is less than about 10 percent by weight. A dilute aqueous solution comprising this composition through the addition of water can be provided.

In still another embodiment, the present disclosure provides a method of forming a first-SiOZ layer in a stacked SiOZ / SiN$_x$ dielectric structure on at least one semiconductor substrate, structure and/or device, the method comprising the steps of: (I) supplying at least one semiconductor structure, at least one precursor semiconductor structure, and/or at least one semiconductor substrate; (II) supplying the composition of the present invention; and (III) using the composition of Step (II) to form a first-SiOZ layer on at least a portion of the at least one semiconductor structure, the at least one precursor semiconductor structure, and/or the at least one semiconductor substrate of Step (I), where the formation of the first-SiOZ layer is utilized as part of a stacked SiOZ / SiN$_x$ dielectric structure.

In still another embodiment, the present disclosure provides a low-[HF] composition according to any of the embodiments disclosed herein, wherein the low-[HF] composition comprises an amount of [HF] that is less than about 0.7 percent by weight $\pm$ about 0.2 percent by weight.

In still another embodiment, the present disclosure provides a method of forming a hydrophilic SiOZ layer on at least one semiconductor substrate, structure and/or device, the method comprising the steps of: (a) supplying at least one semiconductor structure, at least one precursor semiconductor structure, and/or at least one semiconductor substrate; (b) supplying the composition of the invention; and (c) using the composition of Step (b) to form a hydrophilic SiOZ layer on at least a portion of the at least one semiconductor structure, the at least one precursor semiconductor structure, and/or the at least one semiconductor substrate of Step (a).

In still another embodiment, the present disclosure provides a high-[HF] composition according to any of the embodiments disclosed herein, wherein the high-[HF] composition comprises an amount of [HF] that is at least about 1.1 percent by weight $\pm$ 0.2 percent by weight.

In still another embodiment, the present disclosure provides a method of forming a hydrophobic SiOZ layer on at least one semiconductor substrate, structure and/or device, the method comprising the steps of: (i) supplying at least one semiconductor structure, at least one precursor semiconductor structure, and/or at least one semiconductor substrate; (ii) supplying the composition of the invention; and (iii) using the composition of Step (ii) to form a hydrophobic SiOZ layer on at least a portion of the at least one semiconductor structure, the at least one precursor semiconductor structure, and/or the at least one semiconductor substrate of Step (i).

Further combinations and sub-combinations of various concepts are provided below in the Detailed Description and Claims. In particular, all combinations of subject matter appearing as numbered claims at the end of this disclosure are contemplated as being part of the inventive subject matter disclosed herein.

Figure 1 is a graph illustrating sheet resistivity (rho or p) data for wafers which were oxidized using a SiOZ growth formulation both with and without the addition of HCl;

Figure 1B is a graph illustrating reflectance data for two wafers which were oxidized using a SiOZ growth formulation both with and without the addition of HCl;

Figure 1C is a graph illustrating reflectance data for two wafers which were oxidized using a SiOZ growth formulation both with and without the addition of HCl;

Figure 1D is a graph illustrating reflectance data for two wafers which were oxidized using a SiOZ growth formulation both with and without the addition of HCl;

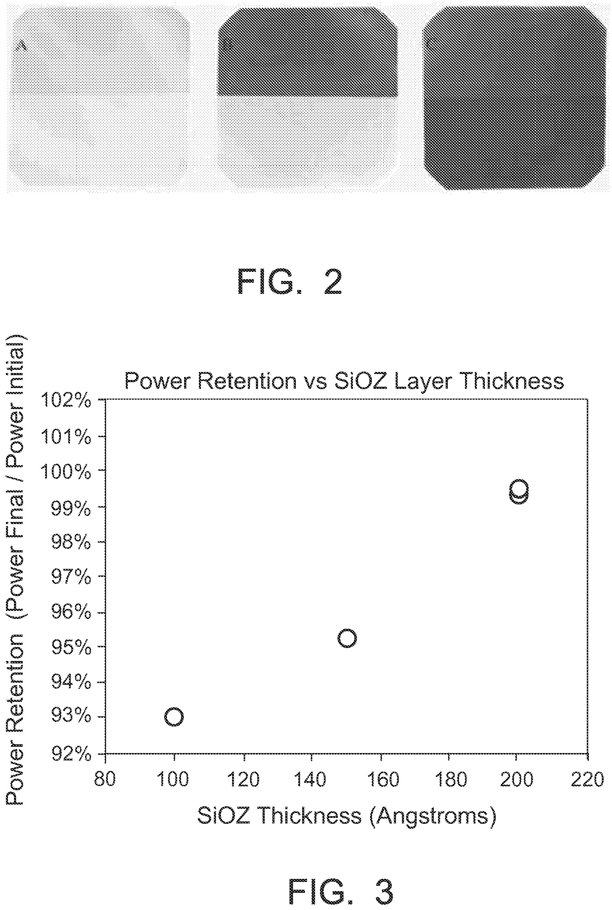

Figures 2A through 2C are three images illustrating three (3) wafers containing SiOZ on half of the surface where: (i) Figure 2A is an image of a wafer with an approximately 400 Angstrom SiOZ layer located on the top half and the bare CZ Si substrate shown on the bottom half; (ii) Figure 2B is an image of a wafer with an approximately 1000 Angstrom SiOZ layer located on the top half and the bare CZ Si substrate shown on the bottom half; and (iii) Figure 2C is an image of a wafer with an approximately 100 Angstrom SiOZ - approximately 700 Angstrom $SiN_x$ stack structure located on the top half and an approximately 700 Angstroms of $SiN_x$ located on the bottom half of a CZ Si substrate; and

Figure 3 is a graph illustrating data the shows that power retention increases with SiOZ thickness in a PID test conducted on solar panels.

DETAILED DESCRIPTION OF THE INVENTION

The present invention relates generally to the field of semiconductors and/or semiconductor structures (e.g., solar cells, etc.), to chemical compositions for manufacturing such semiconductors and/or semiconductor structures, and/or to methods for manufacturing such semiconductors and/or semiconductor structures. In another embodiment, the present invention relates to chemical compositions and methods for controlling surface passivation, dead layer etchback, anti-reflective, potential induced degradation, and other properties of semiconductor surfaces used for various semiconductor applications including, but not limited to, solar cells.

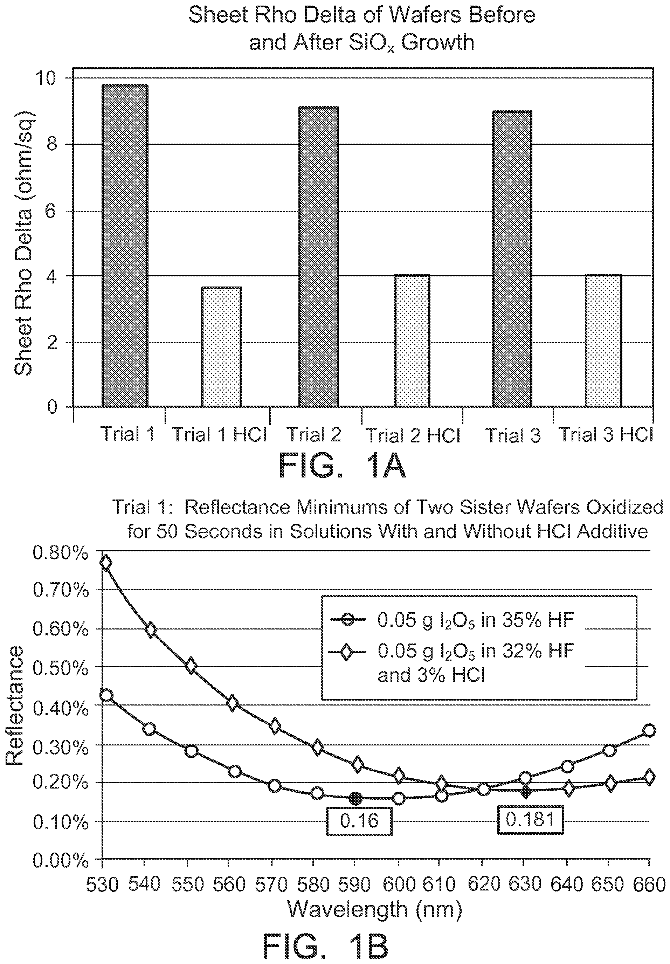

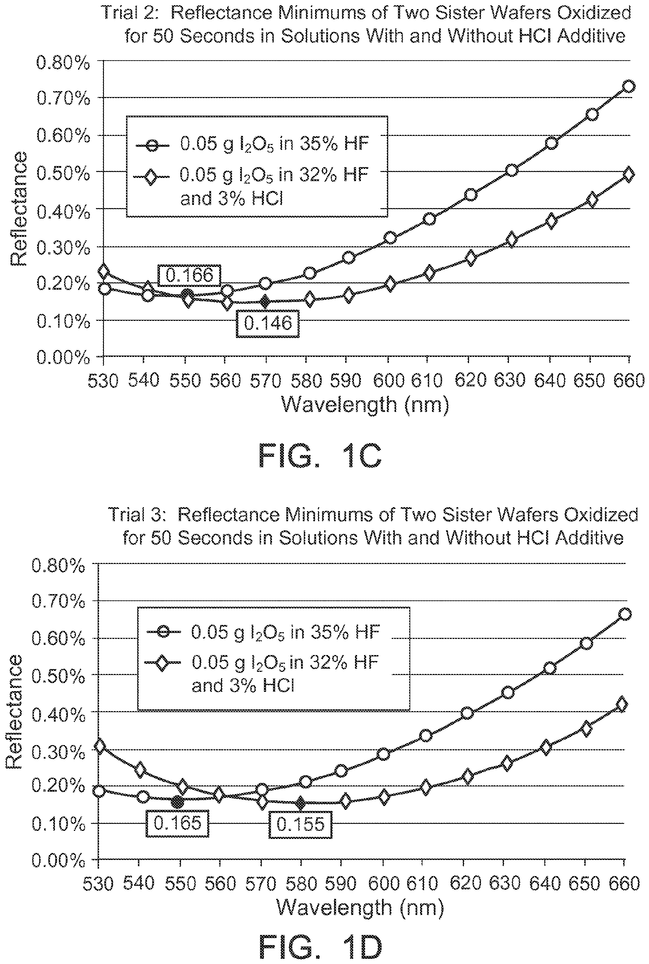

Turning to Figures 1A through 1D, the sheet rho data and reflectance data contained within these Figures is evidence that adding hydrochloric acid (HCl) to an RTWCG formulation in accordance with at least one embodiment of the present invention results in lowered silicon consumption while still producing the desired SiOZ thickness at the surface of a wafer. Put another way, the formulations of the present invention that contain an HCl additive achieve lower etch back while increasing SiOZ yields on the surface of diffused Si wafers. The formulation used to obtain the data of Figures 1A through 1D utilized 32 percent (w/w) hydrofluoric acid concentrations and an $I_2O_5$ concentration of 0.0500 g/L. The wafers used were CZ wafers (1 to 3 ohm bulk resistivity), phosphorus diffused, and phosphosilicate glass ("PSG") cleaned. This particular experiment, which yielded these surprising results, called for the inclusion of HCl to test whether the addition of the acid could result in improvements to the passivation qualities of the resulting SiOZ passivation film. Figure 1A shows that the growth solution utilizing HCl increased the sheet resistivity by less than 50 percent as compared to the growth solution which did not contain HCl. Thus, the inclusion of HCl to the formulation created a solution which etched back to a lesser extent the Si surface.

Figures 1B through 1D are graphs illustrating reflectivity measurement data of wafers which contained a SiOZ layer grown in 50 seconds utilizing a Baker R&D inline tool and an approximately 70 nm $SiN_x$ deposit (e.g., a 78 nm deposit) over the top of the SiOZ layer to yield a SiOZ / $SiN_x$ anti-reflection coating ("ARC") stack. As can be seen, the wavelength corresponding to the minimum reflectance of the wafers containing the SiOZ passivation film grown in a SiOZ growth solution containing HCl (e.g., 3 percent HCl) were red-shifted compared to the wafers containing the SiOZ passivation film grown in a SiOZ growth solution that did not contain HCl. This would imply that the SiOZ / $SiN_x$ stack on the wafers containing a SiOZ passivation layer grown in an HCl-containing solution were significantly thicker than the wafers which contained a SiOZ passivation layer grown in the growth solution that did not contain an HCl additive. While not wishing to be bound to any one explanation, since all of the wafers were sister Czochralski ("CZ") wafers which were textured in the same boat, and since the $SiN_x$ was deposited on all of the wafers in the same plasma-enhanced chemical vapor deposition ("PECVD") run on neighboring levels, it is believed that the $SiN_x$ layer was of nominal thickness from wafer to wafer. It is further believed that the thickness difference between these two distinct stack thicknesses is attributable to a thicker SiOZ layer grown in the growth formulations which included an HCl additive. These unexpected results led to the invention of low-[HF] formulations for growing SiOZ passivation layers which include an HCl additive.

In addition to the discussion above, as the sheet rho data in Figure 1A illustrates, the wafers that were oxidized utilizing a SiOZ growth formulation that included an HCl additive had less etchback than the sister wafers on which the SiOZ layer was grown utilizing a growth formulation that did not contain HCl. To calculate the sheet rho delta, the sheet resistivity (ohm / sq) of a wafer that had been diffused and then PSG-cleaned is subtracted from the sheet resistivity of the same wafer after growing the SiOZ passivation layer; a four-point probe is utilized.

**Examples:**

A Sinton Instruments R&D wafer-lifetime tool was utilized to measure the minority carrier lifetime and the implied open-circuit voltage ("I-Voc") of CZ wafers (1 to 3 ohm bulk resistivity) utilizing the quasi-steady-state photo-conductance method. Groups containing a SiOZ passivation layer, or the experimental groups, had SiOZ grown in varying conditions and were capped by $SiN_x$. The control groups and experimental groups were created by randomizing sister wafers from the same diffusion. The control group wafers did not contain the SiOZ passivation layer. The experimental and control groups were phosphorus diffused in a Semco Engineering LYDOP system and then PSG cleaned using a STANGL wet bench containing a 6 percent HF bath followed by deionized ("DI") water rinse baths, a 80°C DI water bath, and lastly a drier. After the PSG cleaning step, a SiOZ passivation layer was grown on both faces of the wafers in the experimental groups using either a Baker R&D inline tool or a portable ten liter still bath. $SiN_x$ was deposited on both faces of the wafers in the control and experimental groups using a Semco Engineering PECVD. Lifetime and I-Voc was measured after the $SiN_x$ was deposited on both faces and then again after the wafers were passed through a Despatch firing furnace and given a thermal budget at standard metal-firing power set points.

## TABLE 1

| Group | Group Size (wafers) | SiOZ Growth Time (sec) | [HIO₃] (g/L) | [HF] Percent | [HCl] Percent | Sheet rho after PSG Clean (ohm/sq) | Sheet rho after SiOZ Growth (ohm/sq) | Sheet rho delta (ohm/sq) | Lifetime before Firing (μs) | I-Voc before Firing (mV) | Lifetime after Firing (μs) | I-Voc after Firing (mV) | Lifetime Increase over Control (μs) | I-Voc Increase over Control (mV) |
|---|---|---|---|---|---|---|---|---|---|---|---|---|---|---|
| Control | 2 | | | | | | | | 36 | 624 | 112 | 658 | 0 | 0 |
| Trial 1 | 2 | 120 | 0.250 | 2.50 | 0 | 81 | 110 | 29 | 102 | 648 | 174 | 671 | 61 | 13 |

The data in Table 1 relates to a 100 Angstrom-thick SiOZ layer that was grown under low-HF RTWCG solutions absent the HCl additive, leading to an elevated Si consumption and an etchback of 29 ohm/sq. More specifically, Table 1 summarizes the lifetime results from an experiment which utilized a 100 Angstrom SiOZ passivation film grown using a formulation containing 0.25 g/L $I_2O_5$ dissolved in a solution of 2.5 percent HF. The room temperature oxidation step was carried out in a Baker inline R&D tool. The sheet resistivity of the experimental Trial 1 wafers increased by 29 ohm/sq from 81 ohm/sq after PSG etch step to 110 ohm/sq after SiOZ growth. Post firing, the I-Voc of the experimental Trial 1 wafers was 13 mV higher than the Control wafers, or 671 mV and 658 mV, respectively. The measured lifetime of the experimental Trial 1 wafers was 61 μs higher than the lifetime of the Control wafers.

Although there was significant increase in I-Voc and lifetime, the large increase in sheet resistivity (excessive etchback) due to the low-[HF] solution utilized, makes it problematic to utilize a low-[HF] formulation such as described above. Although the passivation qualities of the resulting SiOZ layer would improve a finished cell, all gains would unfortunately be lost due to the low resulting surface dopant concentration making contacting the Ag front contacts difficult. Although the voltage of a cell would benefit from the passivation qualities of the SiOZ, series resistance increases would limit the efficiency of the finished cell.

## Table 2

| Group | Group Size (wafers) | SiOZ Growth Time (sec) | [HIO₃] (g/L) | [HF] Percent | [HCl] Percent | Sheet rho after PSG Clean (ohm/sq) | Sheet rho after SiOZ Growth (ohm/sq) | Sheet rho delta (ohm/sq) | Lifetime before Firing (µs) | I-Voc before Firing (mV) | Lifetime after Firing (µs) | I-Voc after Firing (mV) | Lifetime Increase over Control (µs) | I-Voc Increase over Control (mV) |
|---|---|---|---|---|---|---|---|---|---|---|---|---|---|---|
| Control | 3 | | | | | 84 | | | 42 | 629 | 101 | 654 | 0 | 0 |
| Trial 1 | 3 | 56 | 0.250 | 0.125 | 2.50 | 85 | 96 | 11 | 46 | 632 | 141 | 664 | 40 | 10 |
| Trial 2 | 3 | 31 | 0.250 | 0.257 | 2.50 | 88 | 100 | 12 | 57 | 637 | 157 | 667 | 57 | 13 |
| Trial 3 | 3 | 28 | 0.250 | 0.310 | 2.50 | 81 | 92 | 11 | 57 | 637 | 157 | 667 | 57 | 13 |
| Trial 4 | 3 | 20 | 0.250 | 0.363 | 2.50 | 83 | 94 | 11 | 53 | 635 | 146 | 665 | 46 | 11 |
| Trial 5 | 3 | 18 | 0.250 | 0.416 | 2.50 | 83 | 94 | 11 | 54 | 636 | 145 | 665 | 44 | 11 |

The data in Table 2 relates to increasing the [HF] while keeping [HCl] and [HIO₃] constant and resulted in less time required to grow a 100 Angstrom thick layer of SiOZ. Specifically, Table 2 summarizes the dependency of etchback in light of HF concentration in a system containing, for example, HCl to activate the HIO₃ thereby permitting a significant [HF] lowering without a large etchback component so as to grow 100 Angstroms of SiOZ. As can be seen in Table 2, even though the [HF] is drastically lower than in Table 1, the etchback component is greatly minimized due to the addition of HCl. [HCl] and [HIO₃] were kept constant and the [HF] was increased from 0.125 percent to 0.416 percent. As the data shows, the etchback component of the technology was well behaved over the range of HF concentration. The sheet rho delta was 11 ohm/sq with the exception of Trial 2 wafers which resulted in a 12 ohm/sq sheet rho delta. The wafers were oxidized in a still bath where the [HIO₃] was 0.25 g/L for all the groups and the [HCl] was 2.5 percent for all the groups.

The experiments summarized in Table 2 show that the HCl additive minimizes the etchback in very low [HF] conditions. Thus, HCl permits the use and/or formulation of low [HF] growth solutions that enable thin passivation SiOZ film growth. Lifetime and I-Voc measurements were taken for the groups and the lifetime and I-Voc showed an increase for all the experimental Trial wafers over the Control wafers.

## Table 3

| Group | Group Size (wafers) | SiOZ Growth Time (sec) | [HIO$_3$] (g/L) | [HF] Percent | [HCl] Percent | Sheet rho after PSG Clean (ohm/sq) | Sheet rho after SiOZ Growth (ohm/sq) | Sheet rho delta (ohm/sq) | Lifetime before Firing (µs) | I-Voc before Firing (mV) | Lifetime after Firing (µs) | I-Voc after Firing (mV) | Lifetime Increase over Control (µs) | I-Voc Increase over Control (mV) |
|---|---|---|---|---|---|---|---|---|---|---|---|---|---|---|
| Control | 3 | | | | | 81 | | | 41 | 629 | 106 | 656 | 0 | 0 |
| Trial 1 | 3 | 133 | 0.0500 | 0.363 | 2.50 | 82 | 94 | 12 | 60 | 639 | 151 | 666 | 19 | 10 |
| Trial 2 | 3 | 120 | 0.0500 | 0.573 | 2.50 | 83 | 95 | 12 | 65 | 641 | 149 | 666 | 24 | 10 |
| Trial 3 | 3 | 110 | 0.0500 | 0.834 | 2.50 | 83 | 95 | 12 | 68 | 642 | 165 | 668 | 27 | 13 |
| Trial 4 | 3 | 110 | 0.0500 | 1.09 | 2.50 | 83 | 93 | 10 | 65 | 641 | 154 | 667 | 24 | 11 |

The data in Table 3 relates to further trials with increasing [HF] while keeping [HIO$_3$] and [HCl] constant. There was a slight decrease in the time required to grow 100 Angstroms SiOZ and the resulting SiOZ became hydrophobic at a [HF] between 0.573 percent and 0.834 percent. Specifically, Table 3 summarizes experiments that further explored increasing [HF] in similar conditions as the experiment summarized in Table 2. Compared to the experiment summarized in Table 2, the [HIO$_3$] was lowered from 0.250 g/L to 0.050 g/L for wafer handling reasons. Both sets of experiments were carried out in a still bath where the wafers were manually dipped into the growth solution. The [HCl], [HIO$_3$], and resulting SiOZ thickness were kept constant at 2.5 percent, 0.0500 g/L, and 100 Angstroms. As can be seen in Table 3, the etchback component of the reaction is similar to the experiment summarized in Table 2. The wafers of Trials 3 and 4 resulted in the growth of a hydrophobic SiOZ layer which could imply the incorporation of a fluorinated top surface to the SiOZ layer. The I-Voc and lifetime increases over the Control wafers of the experiment summarized in Table 3 are similar to those in the experiment summarized in Table 2.

## Table 4

| Group | Group Size (wafers) | SiOZ Growth Time (sec) | [HIO₃] (g/L) | [HF] Percent | [HCl] Percent | Sheet rho after PSG Clean (ohm/sq) | Sheet rho after SiOZ Growth (ohm/sq) | Sheet rho delta (ohm/sq) | Lifetime before Firing (μs) | I-Voc before Firing (mV) | Lifetime after Firing (μs) | I-Voc after Firing (mV) | Lifetime Increase over Control (μs) | I-Voc increase over Control (mV) |
|---|---|---|---|---|---|---|---|---|---|---|---|---|---|---|
| Control | 3 | | | | 71 | | | | 36 | 626 | 57 | 638 | 0 | 0 |
| Trial 1 | 3 | 4 | 0.500 | 5.70 | 25.0 | 74 | 86 | 12 | 55 | 636 | 83 | 647 | 26 | 10 |
| Trial 2 | 3 | 14 | 0.250 | 2.85 | 12.5 | 74 | 85 | 11 | 55 | 636 | 82 | 647 | 24 | 9 |
| Trial 3 | 3 | 38 | 0.125 | 1.43 | 6.25 | 71 | 82 | 11 | 51 | 634 | 81 | 647 | 24 | 9 |
| Trial 4 | 3 | 225 | 0.0625 | 0.713 | 3.13 | 72 | 83 | 11 | 54 | 636 | 75 | 644 | 18 | 7 |
| Trial 5 | 3 | 960 | 0.0313 | 0.356 | 1.56 | 75 | 85 | 10 | 59 | 638 | 79 | 646 | 22 | 8 |

The data in Table 4 relates to trials of a concentrated RTWCG formulation containing HCl that was serially diluted using DI; 100 Angstroms of SiOZ were grown in still bath conditions. The time required to create the nominal thickness increased with dilution, but the etchback remained constant at approximately 11 ohm/sq ($\pm$ 1 ohm/sq). Specifically, Table 4 summarizes an experiment carried out in a still bath. The Trial 1 wafers were dipped in a concentrated blend which contained 0.500 g/L $HIO_3$, 5.700 percent [HF], and 25 percent [HCl]. This concentrated blend grew a 100 Angstrom SiOZ layer in 4 seconds. The concentrated blend used for Trial 1 was diluted with DI water in a 1:1 ratio and was utilized to dip the Trial 2 wafers. The blend used on the Trial 2 wafers thus contained 0.250 g/L $HIO_3$, 2.85 percent [HF], and 12.5 percent [HCl] and grew a 100 Angstrom SiOZ layer in 14 seconds. The blend used for Trial 2 was then again diluted with DI water in a 1:1 ratio and was utilized to dip the Trial 3 wafers. The blend used to dip the Trial 3 wafers thus contained 0.125 g/L $HIO_3$, 1.43 percent [HF], and 6.25 percent [HCl], and grew a 100 Angstrom SiOZ layer in 38 seconds. Serial dilutions were similarly performed to conduct the wafers of Trials 4 and 5 which grew a 100 Angstrom SiOZ layer in 225 and 960 seconds, respectively. The etchback component of the SiOZ growth systems did not deviate greatly between the different dilutions. Lifetime and I-Voc increased over the Control wafers for all sets of Trial wafers as can be seen in Table 4.

## Table 5

| Group | Group Size (wafers) | SiOZ Growth Time (sec) | [HIO₃] (g/L) | [HF] Percent | [HCl] Percent | Sheet rho after PSG Clean (ohm/sq) | Sheet rho after SiOZ Growth (ohm/sq) | Sheet rho delta (ohm/sq) | Lifetime before Firing (µs) | I-Voc before Firing (mV) | Lifetime after Firing (µs) | I-Voc after Firing (mV) | Lifetime Increase over Control (µs) | I-Voc Increase over Control (mV) |
|---|---|---|---|---|---|---|---|---|---|---|---|---|---|---|
| Control | 2 | | | | | 84 | | | 41 | 629 | 119 | 658 | 0 | 0 |
| Trial 1 | 2 | 60 | 0.0625 | 1.25 | 0.370 | 84 | 97 | 14 | 87 | 648 | 181 | 670 | 63 | 11 |
| Trial 2 | 2 | 30 | 0.0625 | 1.25 | 0.740 | 84 | 92 | 9 | 59 | 638 | 151 | 664 | 32 | 6 |

The data in Table 5 relates to the time required to create a 100 Angstrom thick layer of SiOZ which was lowered by half along with the etchback which was lowered by 5 ohm/sq by increasing the [HCl] from 0.370 percent to 0.740 percent. Specifically, Table 5 summarizes an experiment that was carried out in the Baker R&D tool and further offers proof of the etchback lowering effect of the HCl additive in an inline tool. The solution used to grow SiOZ on the Trial 2 wafers was formulated using 0.0625 g/L $I_2O_5$, 1.25 percent [HF], and 0.37 percent [HCl]. The etchback component of the SiOZ growth system increased the sheet resistivity by 14 ohm/sq. For the Trial 2 wafers the [HCl] was doubled and the etchback component was minimized resulting in a 9 ohm/sq delta. The SiOZ resulting thickness of both trials was approximately 100 Angstroms. The lifetime and I-Voc of both sets of the Trial wafers increased compared to the Control wafers. The Trial 1 wafers had an I-Voc increase over control of 11 mV, and the Trial 2 wafers increased 6 mV over the Control wafers.

## Table 6

| Group | Group Size (wafers) | SiOZ Growth Time (sec) | [HIO₃] (g/L) | [HF] Percent | [HCl] Percent | Sheet rho after PSG Clean (ohm/sq) | Sheet rho after SiOZ Growth (ohm/sq) | Sheet rho delta (ohm/sq) | Lifetime before Firing (µs) | I-Voc before Firing (mV) | Lifetime after Firing (µs) | I-Voc after Firing (mV) | Lifetime Increase over Control (µs) | I-Voc Increase over Control (mV) |
|---|---|---|---|---|---|---|---|---|---|---|---|---|---|---|
| Control | 3 | | | | | 83 | | | 39 | 627 | 98 | 653 | 0 | 0 |
| Trial 1 | 3 | 60 | 0.0560 | 0.634 | 2.80 | 83 | 95 | 13 | 71 | 644 | 153 | 666 | 56 | 13 |

The data in Table 6 relates to a concentrated RTWCG blend that was diluted using 8 parts DI to 1 part RTWCG blend and then was utilized to oxidize CZ wafers in a Baker in-line tool. Specifically, Table 6 summarizes a dilution test of the concentrated blend summarized in Table 4 but as compared to the experiment of Table 4, which utilized a still bath, the experiment summarized in Table 6 was carried out in a Baker R&D inline tool. The concentrated blend contained 0.500 g/L HIO₃, 5.700 percent [HF], and 25 percent [HCl]. A 1:8 (concentrated blend to DI water) dilution of the concentrated blend was made by adding 6 L of the concentrated blend to 48 L of DI water. The diluted formulation was able to grow a 100 Angstrom-thick SiOZ passivation layer on the wafers of Trial 1. The resulting etchback of 13 ohm/sq was comparable to what was observed in the experiment summarized in Table 4. The wafers of Trial 1, containing the SiOZ / SiN$_x$ stack, had a higher lifetime and I-Voc compared to the control wafers by an average of 56 µs and 13 mV, respectively.

## Table 7

| Group | Group Size (wafers) | SiOZ Growth Time (sec) | [HIO₃] (g/L) | [HF] Percent | [HCl] Percent | Sheet rho after Diffusion (ohm/sq) | Sheet rho after SiOZ Growth (ohm/sq) | Sheet rho delta (ohm/sq) | Lifetime before Firing (µs) | I-Voc before Firing (mV) | Lifetime after Firing (µs) | I-Voc after Firing (mV) | Lifetime Increase over Control (µs) | I-Voc Increase over Control (mV) |
|---|---|---|---|---|---|---|---|---|---|---|---|---|---|---|
| Control | 3 | | | | | 85 | | | 26 | 616 | 68 | 643 | 0 | 0 |
| Trial 1 | 3 | 30 | 0.111 | 0.634 | 2.80 | 84 | 100 | 17 | 38 | 625 | 93 | 652 | 24 | 9 |
| Trial 2 | 3 | 60 | 0.111 | 0.634 | 2.80 | 85 | 103 | 18 | 57 | 637 | 107 | 657 | 38 | 14 |

The data in Table 7 relates to CZ wafers containing PSG which were compared to CZ wafers which were PSG-cleaned before SiOZ growth in low-[HF] RTWCG formulation. The time required to grow a 100 Angstrom-thick SiOZ passivation layer was double for PSG-containing wafers. Specifically, Table 7 summarizes a test which utilized a group of wafers which were not PSG cleaned (Trial 2 wafers) and a group of wafers which were PSG cleaned (Trial 1 wafers) prior to exposure to a SiOZ growth solution in a Baker R&D inline tool. The growth solution contained 0.111 g/L HIO₃, 0.634 percent [HF], and 2.80 percent [HCl] and was diluted from a concentrated blend similarly to the experiment summarized in Table 6. A layer of 100 Angstroms of SiOZ were grown on both groups of wafers. Because the wafers of Trial 2 contained a PSG layer, the required dwell time of this group was longer than the dwell time of the Trial 1 wafers. While not wishing to be bound to any one explanation, this offers proof that the solution removes the PSG layer before it can grow the SiOZ layer. As can be seen in Table 7, the Trial 2 wafers required an additional 30 seconds of oxidation to grow the 100 Angstrom SiOZ passivation layer. The sheet rho delta of the wafers in Trial 1 was 17 ohm/sq and the sheet rho delta of Trial 2 was 18 ohm/sq. Trials 1 and 2 showed an increase in lifetime over control of 24 µs and 38 µs, respectively, and an increase in I-Voc of 9 mV and 14 mV, respectively.

## Table 8

| Group | Group Size (wafers) | SiOZ Growth Time (sec) | [HIO₃] (g/L) | [HF] Percent | [HCl] Percent | Lifetime before Firing (µs) | I-Voc before Firing (mV) | Lifetime after Firing (µs) | I-Voc after Firing (mV) | Lifetime Increase over Baseline (µs) | I-Voc Increase over Baseline (mV) |
|---|---|---|---|---|---|---|---|---|---|---|---|
| Control | 1 | | | | | 19 | 586 | 30 | 598 | 0 | 0 |
| Trial 1 | 1 | 120 | 0.050 | 0.573 | 2.50 | 55 | 615 | 64 | 623 | 34 | 25 |

The data in Table 8 relates to SiOZ formed in low-[HF] RTWCG formulations passivation of a boron diffused CZ wafer. Specifically, Table 8 summarizes a test comparing the ability of the SiOZ passivation layer grown in a low-[HF] room temperature wet chemical growth ("RTWCG") formulation consisting of 0.0500 g/L HIO₃, 0.573 percent [HF] and 2.5 percent [HCl]. A layer of 100 Angstroms of SiOZ was grown on a symmetrical boron-diffused CZ wafer with *in situ* borosilicate glass ("BSG") etching. The wafer was compared to a sister control wafer which did not have the passivation layer grown on it. The BSG on the control wafer was removed in a STANGL wet bench utilizing 6% HF. The SiOZ-containing wafer and the BSG-etched control wafer had SiNx deposited on both faces. This experiment shows that p-type wafers can benefit from the addition of a SiOZ passivation layer to its surface and that the SiOZ layer will block the lifetime destructive effects of SiN$_x$ on boron-doped substrates. As Table 8 shows, the SiOZ-containing wafer's lifetime was more than double compared to the SiN$_x$-only sample, which had the SiN$_x$ directly contacting the p-type surface.

In one embodiment of the present invention, a concentrated low-[HF] room temperature wet chemical growth (RTWCG) solution for growing passivation SiOZ films, hereby referred to as the an inventive concentrate, has the following formulation: 25.00 percent HCl, 5.70 percent HF, 0.1317 percent HIO₃, and 69.168 percent H₂O. The concentrated blend will then need to be diluted with DI water according to the dwell time required to grow a nominal SiOZ thickness. In most cases this dilution will fall between 1:4 (blend to DI water) and 1:26 (blend to DI water).

## Table 9

| | Bare Diffused CZ (PSG Cleaned) | SiOZ as-Grown | SiOZ Drier Thermal Budget | PECVD Thermal Budget | Metal firing thermal budget | DELTAS Metal Firing – Bare CZ |
|---|---|---|---|---|---|---|
| Lifetime (µs) | 46.6 | 38.0 | 42.0 | 72.1 | 72.1 | 25.5 |
| I-Voc (mV) | 628.0 | 622.5 | 625.0 | 639.0 | 639.5 | 11.5 |

Table 9 relates to the thermal budgets commonly utilized in solar cell fabrication as applied to SiOZ passivation layers created on the surface of phosphorus diffused CZ Si wafers in a still bath utilizing a growth solution of 1 part preferred concentrate to 5 parts DI. Specifically, the data of Table 9 shows how thermal budgets commonly utilized in solar cell fabrication affect SiOZ passivation layers. The SiOZ was symmetrical on both faces; the samples did not contain a $SiN_x$ cap in order to assess the SiOZ layer without any influence from the cap. The SiOZ layer was estimated to be 100 Angstroms in thickness and the CZ samples were etched back by 10 ohm/sq from 65 ohm/sq to 75 ohm/sq. While not wishing to be bound to any one explanation, it was surmised from the data of Table 9 that the nominal thermal budgets were sufficient to achieve appreciable gains in LT and I-Voc. The thermal budgets were applied utilizing a Nabertherm P300 bench top oven and consisted of a spin-dryer budget of 100°C for 15 minutes, a PECVD budget of 400°C for 5 minutes, and an estimation of metal firing conditions: 500°C for 20 seconds, 800°C for 5 seconds, and 900°C for 5 seconds.

PID Mitigation:

The low-[HF] RTWCG formulations create a SiOZ layer which, when used as the first layer in a stacked ARC, as can be seen in Figure 2, on the active face of the Si wafer, provide not just the benefits of surface passivation but also PID mitigation. The thickness of the SiOZ layer required for PID mitigation varies with degree of material quality used in creating the solar panel, including the encapsulation materials and the Si wafer used. Generally speaking, it has been observed, that the thickness of SiOZ required is between less than about 100 Angstroms to as high as about 200 Angstroms.

Figure 3 is a graph of power retention (power final / power initial) with increasing first layer SiOZ thicknesses as part of a SiOZ / $SiN_x$ stacked ARC on CZ solar cells. As can be seen, for the materials used in this PID test, the SiOZ thickness which can be said to mitigate PID is 200 Angstroms. The test in this example was conducted on panels containing 60 cells, under the following conditions: 96 hour test period, temperature of 85°C, 85 percent relative humidity, and -1000 V. Figure 3 provides the power retention percentages for SiOZ first layer thicknesses of 100 Angstroms, 150 Angstroms, and 200 Angstroms.

Low-[HF] RTWCG Formulation:

As a non-limiting example, the set of chemicals is a liquid composition that includes A percent of an iodine-containing compound, B percent of a fluoride-containing acid, C percent of a non-oxidizing acid, and D percent of water (to form the balance to 100 percent), where A ranges from about 0.01 to about 0.4, B ranges from about 0.1 to about 10, and C ranges from about 1 to about 50. In one embodiment, A is 0.1317 ± 0.1; B is 5.70 ± 2.5; C is 25.00 ± 12;

and D is the balance by weight. B is less than about 10, more specifically less than 7. The iodine-containing compound comprises $HIO_3$.

The fluoride-containing acid comprises HF. The non-oxidizing acid comprises HCl. The non-oxidizing acid associates with and helps to stabilize the iodine-containing compound, or its intermediary or other compound formed by the iodine-containing compound in solution. The composition comprises a ratio of B to C of about 4:1 to about 1:10, about 3.5:1 to about 1:9.5, about 3:1 to about 1:9, about 2.5:1 to about 1:8.5, about 2:1 to about 1:8, about 1.5:1 to about 1:7.5, about 1:1 to about 1:7, about 1:1.5 to about 1:6.5, about 1:2 to about 1:6, about 1:2.5 to about 1:5.5, about 1:3 to about 1:5, about 1:3.5 to about 1:4.5, or even about 1:4. Here, as well as elsewhere in the specification and claims, individual range values can be combined to form additional and/or non-disclosed ranges. In one embodiment, the ratio is 1:4.3860 ± 2.5. The composition comprises $HIO_3$ in an amount of 0.02 to 0.8 g/L. More specifically in one embodiment, the amount of $HIO_3$ is 0.5 g/L ± 0.15. In another embodiment, the amount of $HIO_3$ is 1.5 g/L ± 0.5.

In one embodiment, the liquid composition can be substantially free of silicon. By "substantially free of" it is meant that the liquid composition contains less than about 7.5 percent by weight or by volume silicon, less than about 5 percent by weight or by volume silicon, less than about 4 percent by weight or by volume silicon, less than about 3 percent by weight or by volume silicon, less than about 2.5 percent by weight or by volume silicon, less than about 2 percent by weight or by volume silicon, less than about 1.5 percent by weight or by volume silicon, less than about 1 percent by weight or by volume silicon, less than about 0.5 percent by weight or by volume silicon, less than about 0.25 percent by weight or by volume silicon, less than about 0.1 percent by weight or by volume silicon, less than about 0.05 percent by weight or by volume silicon, less than about 0.01 percent by weight or by volume silicon, less than about 0.001 percent by weight or by volume silicon, less than about 0.0001 percent by weight or by volume silicon, or even no (or zero) percent by weight or by volume silicon. Here, as well as elsewhere in the specification and claims, individual range values can be combined to form additional and/or non-disclosed ranges.

A diluted mixture comprises the composition and water, wherein the mixture has a dilution ratio (composition: water) of about 1:4 to about 1:26. The oxide of the present invention can be grown by exposing a portion of a surface to the liquid composition. For example, a SiOZ can be grown on a surface that includes silicon.

Concentrated Solutions:

A concentrated, low fluoride-containing acid RTWCG solution for growing passivation SiOZ films comprises: (a) an iodine-containing compound; (b) a fluoride-containing acid; (c) a non-oxidizing acid; and (d) water. The concentrated solution can be said to comprise these components even if, upon mixing the components, they react in solution to form one or more other intermediaries or compounds. The concentrated solution can have the formula: A percent iodine-containing compound, B percent fluoride-containing acid, C percent non-oxidizing acid, D percent water, with percentages listed by weight.

Again, the concentrated solution can be said to comprise such formula even if, upon mixing the components according to these percentages, they react in solution to form one or more other intermediaries or compounds. The sum of A, B, C, and D is 100. As a non-limiting example, the concentrated solution comprises 0.1317 percent $HIO_3$, 5.70 percent HF, 25.00 percent HCl, and 69.168 percent $H_2O$ by weight.

Values of A:

In the concentrated solution, the percent value A (the iodine-containing compound) can vary in the range of 0.01 to 0.4. The value of A can be 0.01, 0.02, 0.03, 0.04, 0.05, 0.06, 0.07, 0.08, 0.09, 0.10, 0.11, 0.12, 0.13, 0.14, 0.15, 0.16, 0.17, 0.18, 0.19, 0.20, 0.21, 0.22, 0.23, 0.24, 0.25, 0.26, 0.27, 0.28, 0.29, 0.30, 0.31, 0.32, 0.33 ,0.34, 0.35, 0.36, 0.37, 0.38, 0.39, or 0.40, and can fall within a range between any two of these values. For example, A = 0.1317 ± 0.01, ± 0.02, ± 0.03, ± 0.04, ± 0.05, ± 0.06, ± 0.07, ± 0.08, ± 0.09, ± 0.10, ± 0.11, ± 0.12, ± 0.13, ± 0.14, ± 0.15, ± 0.16, ± 0.17, ± 0.18, ± 0.19, or ± 0.20, and can fall within a range between any two of these values.

Values of B:

In the concentrated solution, the percent value of B (fluoride-containing acid) can vary at any amount within the range of 0.1 to 10. The value of B is preferably less than 10, most preferably less than 7, for example, less than 6. Exemplary values of B include, but are not limited to, 0.1, 0.10, 0.20, 0.30, 0.40, 0.50, 0.60, 0.70, 0.80, 0.90, 1.00, 1.10, 1.20, 1.30, 1.40, 1.50, 1.60, 1.70, 1.80, 1.90, 2.00, 2.10, 2.20, 2.30, 2.40, 2.50, 2.60, 2.70, 2.80, 2.90, 3.00, 3.10, 3.20, 3.30, 3.40, 3.50, 3.60, 3.70, 3.80, 3.90, 4.00, 4.10, 4.20, 4.30, 4.40, 4.50, 4.60, 4.70, 4.80, 4.90, 5.00, 5.10, 5.20, 5.30, 5.40, 5.50, 5.60, 5.70, 5.80, 5.90, 6.00, 6.10, 6.20, 6.30, 6.40, 6.50, 6.60, 6.70, 6.80, 6.90, 7.00, 7.10, 7.20, 7.30, 7.40, 7.50, 7.60, 7.70, 7.80, 7.90, 8.00, 8.10, 8.20, 8.30, 8.40, 8.50, 8.60, 8.70, 8.80, 8.90, 9.00, 9.10, 9.20, 9.30, 9.40, 9.50, 9.60, 9.70, 9.80, 9.90, or 10.00, and can fall within a range between any two of these values. In another embodiment, B = 5.70 ± 0.10, ± 0.20, ± 0.30, ± 0.40, ± 0.50, ± 0.60, ± 0.70, ± 0.80, ± 0.90, ± 1.00, ± 1.10, ± 1.20, ± 1.30, ± 1.40, ± 1.50, ± 1.60, ± 1.70, ± 1.80, ± 1.90, ± 2.00, ± 2.10, ± 2.20, ± 2.30, ± 2.40, ± 2.50, ± 2.60, ± 2.70, ± 2.80, ± 2.90, ± 3.00, ± 3.10, ± 3.20, ± 3.30, ± 3.40, ± 3.50, ± 3.60, ± 3.70, ± 3.80, ± 3.90, ± 4.00, ± 4.10, ± 4.20, ± 4.30, ± 4.40, ± 4.50, ± 4.60, ± 4.70, ± 4.80, ± 4.90, or ± 5.00, and can fall within a range between any two of these values.

Values of C:

In the concentrated solution, the percent value of C (non-oxidizing acid) can vary in the range of 1 to 50. The value of C can be 1, 2, 3, 4, 5, 6, 7, 8, 9, 10, 11, 12, 13, 14, 15, 16, 17, 18, 19, 20, 21, 22, 23, 24, 25, 26, 27, 28, 29, 30, 31, 32, 33, 34, 35, 36, 37, 38, 39, 40, 41, 42, 43, 44, 45, 46, 47, 48, 49, or 50, and can fall within a range between any two of these values. In one embodiment, C = 25.00 ± 1, ± 2, ± 3, ± 4, ± 5, ± 6, ± 7, ± 8, ± 9, ± 10, ± 11, ± 12, ± 13, ± 14, ± 15, ± 16, ± 17, ± 18, ± 19, ± 20, ± 21, ± 22, ± 23, or ± 24, and can fall within a range between any two of these values.

Values of D:

In the concentrated solution, the percent value of D (water) can vary in the range of 55 to 85. The value of D can be 55, 56, 57, 58, 59, 60, 61, 62, 63, 64, 65, 66, 67, 68, 69, 70, 71, 72, 73, 74, 75, 76, 77, 78, 79, 80, 81, 82, 83, 84, or 85, and can fall within a range between any two of these values. In one embodiment, D = 69.168 ± 1, ± 2, ± 3, ± 4, ± 5, ± 6, ± 7, ± 8, ± 9, ± 10, ± 11, ± 12, ± 13, ± 14, or ± 15, and can fall within a range between any two of these values.

Ratio of B to C:

In the concentrated solution, the percent values of B and C can be determined on the basis of the ratio of B to C. The ratio of B to C can vary from 4:1 to 1:20. For example, the ratio of B to C can be 4.0:1, 3.5:1, 3.0:1, 2.5:1, 2.0:1, 1.5:1, 1:1, 1:1.5, 1:2.0, 1:2.5, 1:3.0, 1:3.5, 1:4.0, 1:4.5, 1:5.0, 1:5.5, 1:6.0, 1:6.5, 1:7.0, 1:7.5, 1:8.0, 1:8.5, 1:9.0, 1:9.5, 1:10.0, 1:10.5, 1:11.0, 1:11.5, 1:12.0, 1:12.5, 1:13.0, 1:13.5, 1:14.0, 1:14.5, 1:15.0, 1:15.5, 1:16.0, 1:16.5, 1:17.0, 1:17.5, 1:18.0, 1:18.5, 1:19.0, 1:19.5, or 1:20.0, and can fall within a range between any two of these values. In one embodiment, the ratio of B to C is 1:4.3860 ± 0.10, ± 0.20, ± 0.30, ± 0.40, ± 0.50, ± 0.60, ± 0.70, ± 0.80, ± 0.90, ± 1.00, ± 1.10, ± 1.20, ± 1.30, ± 1.40, ± 1.50, ± 1.60, ± 1.70, ± 1.80, ± 1.90, ± 2.00, ± 2.10, ± 2.20, ± 2.30, ± 2.40, ± 2.50, ± 2.60, ± 2.70, ± 2.80, ± 2.90, ± 3.00, ± 3.10, ± 3.20, ± 3.30, ± 3.40, ± 3.50, ± 3.60, ± 3.70, ± 3.80, ± 3.90, ± 4.00, ± 4.10, ± 4.20, ± 4.30, ± 4.40, ± 4.50, ± 4.60, ± 4.70, ± 4.80, ± 4.90, or ± 5.00, and can fall within a range between any two of these values.

Examples of Realization:

Depending on the dopant concentration, SiOZ thicknesses have been grown to thicknesses ranging from less than about 20 Angstroms to over 3000 Angstroms. In one non-limiting embodiment, a passivation layer's thickness can be grown between about 20 Angstroms to about 200 Angstroms, or even between about 70 Angstroms and 150 Angstroms, to provide the greatest amount of passivation while minimizing the negative impacts associated with low surface dopant concentrations.

Suitable substrates include but are not restricted to Si, Ge, III-V, I-III-VI, and II-VI compound semiconductors. To grow the SiOZ passivation layer using the low-[HF] growth formulations, a certain minimum surface dopant concentration is required. For instance, for phosphorus-doped Si substrates, the dopant surface concentration ideally would be higher than $10^{17}$ atoms per $cm^3$. SiOZ thin films do not form on lightly doped substrates using the low-[HF] formulations described. The dopant can be any p-type or n-type dopant used in the industry such as boron, arsenic, phosphorus, or gallium.

To create a SiOZ / $SiN_x$ stacked ARC, silicon nitride ($SiN_x$) can be deposited over the SiOZ passivation layer grown in low-[HF] formulations utilizing any $SiN_x$ deposition technique such as APCVD, LPCVD and PECVD. The deposition time can be adjusted to achieve a stack thickness with desired optical qualities. Since the SiOZ layer provides surface passivation, it is preferred to tailor the $SiN_x$ formulations to yield a $SiN_x$ deposit with higher Si-N bond densities which is known in the art to provide better bulk passivation.

Most photovoltaic applications require the passivation layer on only one diffused face, or active face. The low-[HF] formulations grow a SiOZ passivation layer on multi-crystalline (MC) or Czochralski (CZ) wafers which are either p-type diffused or n-type diffused but do not grow a SiOZ passivation layer on low-doped substrates. If one of the faces does not contain a diffused layer, the formulations can be used to grow a passivation layer on only one face even if the solution wets both faces. Chemically junction isolated wafers contain a face on which the diffused portion is completely removed. These can be oxidized in a batch tool where, the wafers are loaded in a carrier and fully immersed in the low-[HF] RTWCG solution. If both faces contain a diffused layer, then the wafer must be floated over the solution so that the liquid wets only the face on which the SiOZ passivation film is beneficial.

SiOZ passivation layers grown in low-[HF] RTWCG formulations have been used for surface passivation of silicon photovoltaic cell. Textured wafers are phosphorus diffused using any diffusion equipment to yield a sheet rho of between 65 ohm/sq to 75 ohm/sq. The wafers are then stacked for plasma edge isolation and then set in carriers and the PSG is cleaned off in a batch wet bench. The wafers are then passed through an inline tool and floated over the low-[HF] RTWCG chemistry to yield a 100 Angstrom-thick SiOZ passivation layer. The resulting passivated surface will become the active side on which the Silver grid metallization will be screen printed. The wafers are then loaded into a CVD equipment to deposit $SiN_x$ on the active face which now contains the SiOZ layer; the $SiN_x$ thickness is adjusted to compensate for the additional SiOZ layer thickness. The rear and front metal is printed and then the contacts are fired in an inline furnace.

As can be noted from the above examples, in most cases, the SiOZ layer does not need a special anneal step. The annealing of the SiOZ layer is concomitant in the process and receives the required thermal budgets from the $SiN_x$ deposition step as well as from the metal firing step.

In another example, the SiOZ passivation layer obtained from the low-[HF] RTWCG formulations has been successfully utilized for surface passivation of the active face of silicon solar cells where post diffusion, the wafers underwent a chemical junction isolation step to completely remove the phosphorus diffusion from one of the faces. After the chemical isolation step the wafers were fully immersed into the low-[HF] RTWCG formulation to create a passivation layer only on the active side that still contained an emitter. Afterwards, the wafers' active side were $SiN_x$-deposited and the front and rear metal contacts were screen printed and fired.

Silicon Source:

As noted above, in one embodiment the concentrated solution of the present invention is substantially free of silicon. For example, no silicon source (such as colloidal silica, $SiO_2$, or other soluble silicates) is intentionally added to the solution.

Dilution:

The concentrated solution can be diluted with DI water according to the dwell time required to grow a nominal SiOZ thickness. In most cases this dilution will fall between 1:4 (concentrate to DI water) and 1:26 (concentrate to DI water). For example, dilution ratios include 1:1, 1:1.5, 1:2.0, 1:2.5, 1:3.0, 1:3.5, 1:4.0, 1:4.5, 1:5.0, 1:5.5, 1:6.0, 1:6.5, 1:7.0, 1:7.5, 1:8.0, 1:8.5, 1:9.0, 1:9.5, 1:10.0, 1:10.5, 1:11.0, 1:11.5, 1:12.0, 1:12.5, 1:13.0, 1:13.5, 1:14.0, 1:14.5, 1:15.0, 1:15.5, 1:16.0, 1:16.5, 1:17.0, 1:17.5, 1:18.0, 1:18.5, 1:19.0, 1:19.5, 1:20.0, 1:20.5, 1:21, 1:21.5, 1:22.0, 1:22.5, 1:23.0, 1:23.5, 1:24.0, 1:24.5, 1:25.0, 1:25.5, 1:26.0, or 1:26, and can fall within a range between any two of these values.

Substrates:

Suitable substrates include but are not restricted to Si, Ge, III-V, I-III-VI, and II-VI compound semiconductors. To grow the SiOZ passivation layer using the low-[HF] growth formulations, a certain minimum surface dopant concentration is required. For instance, for phosphorus-doped Si substrates, the dopant surface concentration of the Si substrate must be greater than $10^{17}$ atoms per $cm^3$. The SiOZ thin films do not form on lightly doped or intrinsic substrates using the low-[HF] formulations described. The dopant can be any p-type or n-type dopant used in the industry such as boron, arsenic, phosphorus, or gallium. For photovoltaic applications, the low-[HF] formulations can be used to grow a SiOZ passivation layer on either multi-crystalline ("MC") or Czochralski ("CZ") wafers.

Oxide Thicknesses:

In addition to, or in the alternative to, the disclosure contained above, depending on the dopant concentration, SiOZ thicknesses can be grown to thicknesses ranging from less than about 20 Angstroms to over 3000 Angstroms. A preferred surface passivation layer's thickness can be grown between about 20 Angstroms to about 200 Angstroms, such as 20, 25, 30, 35, 40, 45, 50, 55, 60, 65, 70, 75, 80, 85, 90, 95, 100, 105, 110, 115, 120, 125, 130, 135, 140, 145, 150, 155, 160, 165, 170, 175, 180, 185, 190, 195, 200 Angstroms, and can fall within a range between any two of these values. Oxide growth times can vary between about 3 seconds and about 1000 seconds. For example, oxide growth times include 3, 4, 5, 6, 7, 8, 9, 10, 15, 20, 25, 50, 75, 100, 150, 200, 250, 300, 350, 400, 450, 500, 550, 600, 650, 700, 750, 800, 850, 900, 950, 1000 seconds, and can fall within a range between any two of these values.

Surface Characteristics:

Si wafers treated with the low fluoride-containing acid RTWCG formulations can be characterized in that they exhibit a sheet rho after SiOZ oxide growth of about 80 ohm/sq to about 110 ohm/sq, such as about 85 ohm/sq to about 100 ohm/sq. They exhibit a sheet rho delta of about 3 ohm/sq to about 20 ohm/sq, such as about 12 $\pm$ 3 ohm/sq. In addition, the semiconductor wafers are characterized in that they are red-shifted compared with wafers that compared to the wafers containing a passivation film grown in formulation that do not contain a non-oxidizing acid such as HCl. For example, the reflectance minimum of a Si wafer treated with a low fluoride-containing acid RTWCG formulation is at a wavelength of about 20 nm to about 80 nm greater, or even about 20 nm to about 45 nm greater, than that of a wafer treated in a formulation that does not contain a non-oxidizing acid such as HCl. Semiconductor wafers treated with the low fluoride-containing acid RTWCG formulations may also be characterized in that they contain on their surface trace amounts of I, CI, F, Br, and/or P, and/or their ions. In addition, the SiOZ layer may comprise a fluorinated top surface.

SiOZ / SiNx Stacked ARC:

To create a SiOZ / SiN$_x$ stacked ARC, silicon nitride (SiN$_x$) can be deposited over the SiOZ passivation layer grown in low-[HF] formulations utilizing any SiN$_x$ deposition technique such as APCVD, LPCVD and PECVD. The deposition process can be adjusted to optimize the stack thickness, optical qualities, passivation properties, and charge characteristics of the layers and composite stack.

While not wishing to be bound to any one or more advantages, in one or more embodiments the present invention enables the formation of at least one oxide layer on a semiconductor device that mitigates potential induced degradation (PID) therein. As would be apparent to those of skill in the art, an oxide layer for PID control can be formed to have any suitable thickness and does not have a set value or range of values as the thickness of this oxide layer for PID control will vary from device to device, from application to application, from manufacture method to manufacture method, etc. As mentioned above, one of skill in the art will be able to determine the necessary thickness, or range of thickness, for an oxide layer to control PID where such PID control is desirable.

While in accordance with the patent statutes the best mode and certain embodiments of the invention have been set forth, the scope of the invention is not limited thereto, but rather by the scope of the attached claims.

**Claims**

1. A composition for Si$_x$O$_y$Z$_z$ growth with reduced etchback properties comprising:

    (A) an iodine compound comprising HIO$_3$;
    (B) a first acid comprising HF;
    (C) a second, non-oxidizing, acid comprising HCl; and
    (D) water,

    wherein the composition comprises A weight percent of the iodine compound (A), B weight percent of the first acid (B), C weight percent of the second, non-oxidizing, acid (C), and D weight percent water, wherein the sum of A, B, C, and D is 100, wherein the iodine compound (A) is present in the range of about 0.01 weight percent to about 0.4 weight percent,
    wherein the first acid (B) is present in the range of about 0.1 weight percent to about 10 weight percent,
    wherein the second, non-oxidizing, acid (C) is present in the range of about 1 weight percent to about 50 weight percent, and
    D is the balance.

2. The composition of claim 1, wherein A is 0.1317 $\pm$ 0.1 weight percent, B is 5.70 $\pm$ 2.5 weight percent, and C is 25.00 $\pm$ 12 weight percent.

3. The composition of claim 1 or 2, wherein B is less than 7 weight percent.

4. The composition of any of claims 1 to 3, wherein the ratio of B to C is from 4:1 to 1:20, or even where the ratio of B to C is 1:4.3860 $\pm$ 2.5.

5. The composition of any of claims 1 to 4, wherein the iodine compound is HIO$_3$ which is present in an amount of from 0.02 g/L to 0.8 g/L, or is present in an amount of 0.5 $\pm$ 0.15 g/L, or even is present in an amount of 1.5 $\pm$ 0.5 g/L.

6. The composition of any of claims 1 to 5, wherein the composition is substantially free of silicon.

7. A dilute aqueous solution comprising the composition of any of claims 1 to 6 and water.

8. The dilute aqueous solution of claim 7, wherein the dilute aqueous solution comprises the composition of any of claims 1 to 6 and water in a ratio of from 1:4 to 1:26.

9. The composition of any of claims 1 to 8, wherein component (B) is HF and the composition is a low-[HF] RTWCG composition where the amount of [HF] in the low-[HF] composition is 0.7 percent by weight $\pm$ 0.2 percent by weight.

10. The composition of any of claims 1 to 8, wherein component (B) is HF and the composition is a high-[HF] composition where the amount of [HF] in the high-[HF] composition is at least 1.1 percent by weight $\pm$ 0.2 percent by weight.


**Patentansprüche**

1. Zusammensetzung für $Si_xO_yZ_z$ Wachstum mit reduzierten Rückätzeigenschaften, umfassend:

   (A) eine Iodverbindung, umfassend $HIO_3$;
   (B) eine erste Säure, umfassend HF;
   (C) eine zweite, nicht-oxidierende Säure, umfassend HCl; und
   (D) Wasser,

   wobei die Zusammensetzung A Gewichtsprozent der Iodverbindung (A), B Gewichtsprozent der ersten Säure (B), C Gewichtsprozent der zweiten, nichtoxidierenden Säure (C) und D Gewichtsprozent Wasser umfasst, wobei die Summe von A, B, C und D 100 beträgt,
   wobei die Iodverbindung (A) in einem Bereich von etwa 0,01 Gewichtsprozent bis etwa 0,4 Gewichtsprozent vorliegt,
   wobei die erste Säure (B) in einem Bereich von etwa 0,1 Gewichtsprozent bis etwa 10 Gewichtsprozent vorliegt,
   wobei die zweite, nicht-oxidierende Säure (C) in einem Bereich von etwa 1 Gewichtsprozent bis etwa 50 Gewichtsprozent vorliegt und
   D der Rest ist.

2. Zusammensetzung nach Anspruch 1, wobei A 0,1317 $\pm$ 0,1 Gewichtsprozent beträgt, B 5,70 $\pm$ 2,5 Gewichtsprozent beträgt und C 25,00 $\pm$ 12 Gewichtsprozent beträgt.

3. Zusammensetzung nach Anspruch 1 oder 2, wobei B weniger als 7 Gewichtsprozent beträgt.

4. Zusammensetzung nach einem der Ansprüche 1 bis 3, wobei das Verhältnis von B zu C von 4 : 1 bis 1 : 20 beträgt, oder sogar wobei das Verhältnis von B zu C 1 : 4,3860 $\pm$ 2,5 beträgt.

5. Zusammensetzung nach einem der Ansprüche 1 bis 4, wobei die Iodverbindung $HIO_3$ ist, welche in einer Menge von 0,02 g/L bis 0,8 g/L vorliegt, oder in einer Menge von 0,5 $\pm$ 0,15 g/L vorliegt, oder sogar in einer Menge von 1,5 $\pm$ 0,5 g/L vorliegt.

6. Zusammensetzung nach einem der Ansprüche 1 bis 5, wobei die Zusammensetzung im Wesentlichen frei von Silicium ist.

7. Verdünnte, wässrige Lösung, umfassend die Zusammensetzung nach einem der Ansprüche 1 bis 6 und Wasser.

8. Verdünnte, wässrige Lösung nach Anspruch 7, wobei die verdünnte, wässrige Lösung die Zusammensetzung nach einem der Ansprüche 1 bis 6 und Wasser in einem Verhältnis von 1 : 4 bis 1 : 26 umfasst.

9. Zusammensetzung nach einem der Ansprüche 1 bis 8, wobei Bestandteil (B) HF ist und die Zusammensetzung eine niedrig-[HF] RTWCG Zusammensetzung ist, bei der die Menge an [HF] in der niedrig-[HF] Zusammensetzung 0,7 Gewichtsprozent $\pm$ 0,2 Gewichtsprozent beträgt.

10. Zusammensetzung nach einem der Ansprüche 1 bis 8, wobei Bestandteil (B) HF ist und die Zusammensetzung eine hoch-[HF] Zusammensetzung ist, bei der die Menge an [HF] in der hoch-[HF] Zusammensetzung mindestens

1,1 Gewichtsprozent $\pm$ 0,2 Gewichtsprozent beträgt.

**Revendications**

1.  Composition de croissance de $Si_xO_yZ_z$ présentant des propriétés réduites de gravure en retrait comprenant:

    (A) un composé d'iode comprenant du $HIO_3$;
    (B) un premier acide comprenant du HF;
    (C) un deuxième acide non oxydant comprenant du HCl; et
    (D) de l'eau,

    dans laquelle la composition comprend A pour-cent en poids du composé d'iode (A), B pour-cent en poids du premier acide (B), C pour-cent en poids du deuxième acide non oxydant (C) et D pour-cent en poids d'eau, dans laquelle la somme de A, B, C et D est 100,
    dans laquelle le composé d'iode (A) est présent dans l'intervalle compris entre environ 0,01 pour-cent en poids et environ 0,4 pour-cent en poids,
    dans laquelle le premier acide (B) est présent dans l'intervalle compris entre environ 0,1 pour-cent en poids et environ 10 pour-cent en poids,
    dans laquelle le deuxième acide non oxydant (C) est présent dans l'intervalle compris entre environ 1 pour-cent en poids et environ 50 pour-cent en poids, et
    D est le reste.

2.  Composition selon la revendication 1, dans laquelle A est 0,1317 $\pm$ 0,1 pour-cent en poids, B est 5,70 $\pm$ 2,5 pour-cent en poids et C est 25,00 $\pm$ 12 pour-cent en poids.

3.  Composition selon la revendication 1 ou 2, dans laquelle B inférieur à 7 pour-cent en poids.

4.  Composition selon les quelconques revendications 1 à 3, dans laquelle le rapport de B à C va de 4:1 à 1:20, ou même dans laquelle le rapport de B à C est de 1:4,3860 $\pm$ 2,5.

5.  Composition selon les quelconques revendications 1 à 4, dans laquelle le composé d'iode est le $HIO_3$ présent dans une quantité allant de 0,02 g/L à 0,8 g/L ou est présent dans une quantité de 0,5 $\pm$ 0,15 g/L ou même est présent dans une quantité de 1,5 $\pm$ 0,5 g/L.

6.  Composition selon les quelconques revendications 1 à 5, dans laquelle la composition est substantiellement exempte de silicium.

7.  Solution aqueuse diluée comprenant la composition selon les quelconques revendications 1 à 6 et de l'eau.

8.  Solution aqueuse diluée selon la revendication 7, dans laquelle la solution aqueuse diluée comprend la composition selon les quelconques revendications 1 à 6 et de l'eau dans un rapport de 1:4 à 1:26.

9.  Composition selon les quelconques revendications 1 à 8, dans laquelle le composant (B) est le HF et la composition est une composition RTWCG pauvre en [HF], dans laquelle la quantité de [HF] dans la composition pauvre en [HF] est 0,7 pour-cent en poids $\pm$ 0,2 pour-cent en poids.

10. Composition selon les quelconques revendications 1 à 8, dans laquelle le composant (B) est le HF et la composition est une composition riche en [HF], dans laquelle la quantité de [HF] dans la composition riche en [HF] est d'au moins 1,1 pour-cent en poids $\pm$ 0,2 pour-cent en poids.

## Sheet Rho Delta of Wafers Before and After SiO$_x$ Growth

FIG. 1A

## Trial 1: Reflectance Minimums of Two Sister Wafers Oxidized for 50 Seconds in Solutions With and Without HCl Additive

FIG. 1B

Trial 2: Reflectance Minimums of Two Sister Wafers Oxidized
for 50 Seconds in Solutions With and Without HCl Additive

FIG. 1C

Trial 3: Reflectance Minimums of Two Sister Wafers Oxidized
for 50 Seconds in Solutions With and Without HCl Additive

FIG. 1D

# FIG. 2

Power Retention vs SiOZ Layer Thickness

# FIG. 3

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 6080683 A
- US 6593077 B
- US 6613697 B
- WO 2012036760 A